## Europäisches Patentamt

## European Patent Office

## Office européen des brevets

(19)

(11) Veröffentlichungsnummer: **0 115 629**
**B1**

(12) **EUROPÄISCHE PATENTSCHRIFT**

(45) Veröffentlichungstag der Patentschrift:
08.06.88

(51) Int. Cl.⁴: **C 23 C 14/34,** C 23 C 14/08

(21) Anmeldenummer: **83113069.3**

(22) Anmeldetag: **24.12.83**

(54) **Targets für die Kathodenzerstäubung.**

(30) Priorität: **10.01.83 DE 3300525**

(43) Veröffentlichungstag der Anmeldung:
**15.08.84 Patentblatt 84/33**

(45) Bekanntmachung des Hinweises auf die Patenterteilung:
**08.06.88 Patentblatt 88/23**

(84) Benannte Vertragsstaaten:
**AT CH DE FR GB LI NL SE**

(56) Entgegenhaltungen:
**FR-A-2 441 582**
**US-A-3 438 885**
**US-A-3 749 658**

**JOURNAL OF THE ELECTROCHEMICAL SOCIETY,**
Band 19, Nr. 10, Oktober 1972, Seiten 1368-1374; D.B.
FRASER u.a.: "Highly conductive, transparent
films of sputtered In2-alphaSnalphaO3-y"

(73) Patentinhaber: **Merck Patent Gesellschaft mit**
**beschränkter Haftung, Frankfurter Strasse 250,**
**D-6100 Darmstadt (DE)**

(72) Erfinder: **Klein, Hans Dietrich, Dr., Haydnweg 32,**
**D-6100 Darmstadt (DE)**

## Beschreibung

Die Anmeldung betrifft oxidkeramische Targets für die magnetfeldverstärkte Kathodenzerstäubung auf Basis von heiß gepressten Indiumoxid/Zinnoxid-Gemischen.

Solche Targets sind an sich bekannt und es sind auch Anwendungen für solche Targets zur Erzeugung transparenter, elektrisch leitfähiger Schichten bekannt.

Da die Metalloxide, die unter Anwendung von Druck und hoher Temperatur zu Targets verpresst werden, Nichtleiter sind, ist es üblich diese Targets durch Anwendung von Hochfrequenz zu zerstäuben, wobei sich auch Nichtleiter ohne weiteres zerstäuben lassen. Für die großtechnische Anwendung ist die Hochfrequenzzerstäubung jedoch wenig geeignet. Für die an sich vorzuziehende Gleichspannungszerstäubung sind primär metallische Targets, nicht jedoch die oxidkeramische Targets geeignet.

Bei der Verwendung metallischer Targets muß jedoch zur Herstellung transparenter Oxidschichten während oder nach dem Aufbringen des Targetmaterials auf die zu beschichtende Oberfläche eine Oxidation stattfinden. Diese Verfahrensweise führt in der Regel nicht zu befriedigenden Schichten und ist auch nicht bei allen zu beschichtenden Materialien möglich.

Es bestand deshalb die Aufgabe, oxidkeramische Targets zu finden, die auch für die Gleichspannungszerstäubung geeignet sind und dabei mit hoher Leistungsdichte in der sogenannten magnetfeldverstärkten Kathodenzerstäubung eingesetzt werden können.

Es wurde nun gefunden, daß Targets, die einerseits eine sehr hohe Dichte aufweisen und die andererseits in ihrem Sauerstoffgehalten so abgereichert sind, daß sich eine relativ hohe elektrische Leitfähigkeit ergibt, mit sehr gutem Erfolg in Hochleistungs-Zerstäuberanlagen mit Gleichspannungszerstäubung eingesetzt werden können. Überraschenderweise werden mit diesen Targets, deren Sauerstoffgehalt so weit erniedrigt sein kann, daß bereits metallische Anteile enthalten sind, trotzdem sehr homogene Metalloxid-Schichten erzeugt, die keinerlei Metalleinschlüsse enthalten, die die Transparenz der Schicht beeinträchtigen könnten.

Gegenstand der Erfindung sind demgemäß oxidkeramische Targets für die magnetfeldverstärkte Kathodenzerstäubung auf Basis von heiß gepressten Indiumoxid/Zinnoxid-Gemischen mit einer Dichte von zumindest 75 % der theoretischen Dichte, die dadurch gekennzeichnet sind, daß sie im Sauerstoffgehalt gegenüber der stöchiometrischen Zusammensetzung so abgereichert sind, daß sie eine elektrische Leitfähigkeit entsprechend einem spezifischen Widerstand von 0,6 bis 0,1 $\Omega$. cm besitzen.

Wesentlicher Vorteil der erfindungsgemäßen Targets ist deren gute Eignung für die Hochleistungszerstäubung mit Gleichspannung. Entscheidend dafür ist, daß die Targets neben einer hohen Dichte auch eine relativ hohe Leitfähigkeit aufweisen.

Das Verfahren zur Heißpressung von oxidkeramischen Targets ist an sich bekannt. Dabei werden die Metalloxidpulver in beheizbaren Pressen bei Sintertemperatur, die in der Regel etwa 2/3 der absoluten Schmelztemperatur beträgt, hohen Drucken von bis zu mehreren hundert Atmosphären ausgesetzt. Je nach der angewendeten Temperatur, dem Druck und den Materialeigenschaften des speziellen Metalloxids werden dabei Keramikkörper unterschiedlicher Dichte erhalten.

Targets auf Basis von Indium- und Zinnoxid sind mit Dichten von etwa 50-70 % der theoretischen Dichte käuflich erhältlich. Targets mit einer Dichte von mindestens 75 % der Dichte des festen Stoffes, die durch Heißpressen von Indiumoxid/Zinnoxid-Gemischen hergestellt werden können, werden sowohl in der DOS 31 12 104 als auch im J. Electrochem. Soc., Band 19, Nr. 10 (1972), Seiten 1368-1374 beschrieben. In der US-A-3 749 658 wird auch beschrieben, daß Indiumoxid-Zinnoxid-Targets ungenannter Dichte durch Heißpressen in Graphitformen hergestellt werden können. Es wurde nun jedoch gefunden, daß besonders vorteilhafte Targets hergestellt werden können, wenn das Heißpressen bei bestimmten Temperatur-und Druckbedingungen in einer reduzierenden Atmosphäre so lange durchgeführt wird, daß ein im Sauerstoffgehalt abgereichertes Target mit hoher Leitfähigkeit entsteht. Gegenstand der Erfindung ist demgemäß auch ein Verfahren zur Herstellung von oxidkeramischen Targets für die magnetfeldverstärkte Kathodenzerstäubung auf Basis von heiß gepressten Indiumoxid/Zinnoxid-Gemischen mit einer Dichte von mindestens 75 % der theoretischen Dichte, das dadurch gekennzeichnet ist, daß das Metalloxid-Gemisch in einer reduzierenden Atmosphäre bei einem Druck von 50 bis 600 kg/cm$^2$ und einer Temperatur von 850-1000° C so lange verpresst wird, daß das Target eine elektrische Leitfähigkeit entsprechend einem spezifischen Widerstand von 0,6 bis 0,1 $\Omega$. cm erhält.

Die Presstemperatur von 850-1000° C liegt wesentlich unter der für Indiumoxid mit einem Schmelzpunkt von 1910° C und Zinnoxid mit einem Schmelzpunkt von 1620° C nach der oben genannten Faustregel zu erwartenden Sintertemperatur. Tatsächlich zeigen mikroskopische Untersuchungen der gepressten Materialien, daß kein normaler Sintervorgang stattfindet. Beim normalen Sintern ist nämlich in der Regel durch Auflösung sehr feiner Anteile und entsprechendem Wachstum größerer Teilchen eine Vergröberung der Teilchenstruktur zu beobachten. Dies ist im Falle der Indiumoxid/Zinnoxid-Targets nicht zu beobachten. Vielmehr bleibt die Teilchengröße weitgehend konstant.

Wesentlich ist, daß das erfindungsgemäße Verfahren in einer reduzierenden Atmosphäre durchgeführt wird. Dazu wird das Ausgangsmaterial vorzugsweise in einer Graphitform verpresst. Um eine stärker reduzierende Atmosphäre zu erzeugen, kann dem Metalloxidpulver auch Kohle oder eine kohlenstoffliefernde Substanz zugesetzt werden. Bewährt haben sich beispielsweise Deckschichten zwischen Metalloxidpulver und Presstempel aus einem organischen Material, zum Beispiel auf Cellulosebasis, wie zum Beispiel Papier. Es ist anzunehmen, daß die bei dem Verkokungsprozess, der bei den hohen Temperaturen abläuft, entstehenden Gase eine teilweise Reduktion des Indiumoxids bewirken. Es kann angenommen werden, daß das dabei entstehende metallische Indium, das in flüssiger Form vorliegt, als Gleitmittel für das Oxidpulver dient und so eine erhebliche Verdichtung des Pulvers erlaubt.

Ohne jedoch durch diese Theorie gebunden zu sein, kann festgestellt werden, daß die nach dem erfindungsgemäßen Verfahren hergestellten Targets ein erhebliches Sauerstoffdefizit aufweisen, was sich schon im Aussehen der durch den Anteil von Suboxiden bis hin zum metallischen Zustand grau gefärbten Targets äußert.

Je nach der angewendeten Temperatur und der Presszeit können daher Targets mit bis zu 90 bis 95 % der theoretischen Dichte erhalten werden.

Durch Anwendung zu hoher Temperaturen bzw. zu langer Presszeiten kann es zu einer vollständigen Reduktion des Metalloxids kommen, was zum Herauslaufen des flüssigen Metalls aus der Pressform führt. Diese unerwünschten Bedingungen können jedoch durch einige Vorversuche ausgeschlossen werden. Es hat sich gezeigt, daß insbesondere bei Temperaturen von 880 bis 920° C sehr gute Resultate erzielt werden. Dabei beträgt die Gesamtpresszeit einschließlich der Aufheizperiode etwa 1 bis 2 Stunden, wobei maximal etwa eine halbe Stunde, vorzugsweise 10 Minuten, bei Maximaltemperatur gepresst wird.

Der Pressgrad, das heißt das Verhältnis der beim Pressen erzeugten Dichte in Bezug auf die theoretische Dichte der Festsubstanz kann durch die Festlegung des Kompressionsweges des Presstempels vorher festgelegt werden, wobei bei der Bestimmung des Kompressionsweges selbstverständlich auch die thermische Ausdehnung der Pressform und des Presstempels zu berücksichtigen ist. Die Abhängigkeit des Pressgrades vom Kompressionsweg kann für jede Pressform und jede Presstemperatur leicht empirisch festgelegt werden.

Der Pressdruck ist an sich nicht besonders kritisch und kann maximal bei dem von der Graphitform ertragenen Druck von etwa 600 kg/cm$^2$ liegen. Es hat sich jedoch gezeigt, daß so hohe Drucke nicht erforderlich sind, um gute Resultate zu erreichen. Tatsächlich werden schon bei ungewöhnlich niedrigen Drucken von etwa 50 kg/cm$^2$ sehr gute Ergebnisse erzielt. Vorzugsweise wird daher in einem Bereich von etwa 50 bis 100 kg/cm$^2$, insbesondere bei etwa 70 kg/cm$^2$, gearbeitet. Diese niedrigen Pressdrucke ermöglichen eine lange Standzeit der dadurch wenig beanspruchten Presse.

Mit dem erfindungsgemäßen Verfahren werden Indiumoxid/ Zinnoxid-Targets hergestellt, die als Hauptbestandteil Indiumoxid enthalten. Der Zinnoxid-Gehalt kann etwa zwischen 1 und 20 Gew.-% schwanken. Vorzugsweise sind etwa 9 bis 11 Gew.-% enthalten.

Durch wenige routinemäßige Vorversuche können die für ein bestimmtes Ergebnis in Bezug auf Targetdichte und Zusammensetzung optimalen Bedingungen ermittelt werden. Dabei kann von der Regel ausgegangen werden, daß durch eine Verlängerung der Pressdauer und eine Erhöhung der Presstemperatur sowohl dichtere Targets als auch Targets mit höherem Sauerstoffdefizit erhalten werden. Je höher das Sauerstoffdefizit ist, desto höher ist auch die Leitfähigkeit der Targets. In der Regel wird man die Bedingungen so wählen, daß man Targets mit einer Leitfähigkeit entsprechend einem spezifischen Widerstand von etwa 0,6 bis 0,1 Ω. cm erhält.

Die Leitfähigkeit der Targets kann gegebenenfalls auch durch Zumischen von Metallpulver vor dem Pressen zu dem Metalloxidpulver gesteuert werden. Es können dabei bis zu 2 Gew.-% Indium- und/oder Zinn beigemischt werden.

Neben der bereits genannten guten Eignung der erfindungsgemäßen Targets für die Hochleistungsgleichspannungs-Zerstäubung sind diese aufgrund ihrer hohen Dichte auch mechanisch besonders stabil. Dies zusammen mit der ebenfalls sehr hohen Wärmeleitfähigkeit, die es gestattet, die beim Zerstäuben auftretende Wärme schnell abzuführen, ist ein weiterer wesentlicher Vorteil der erfindungsgemäßen Targets.

Die Targets können in vorteilhafter Weise für die Beschichtung von insbesondere flächigen Substraten eingesetzt werden, wie zum Beispiel bei der Herstellung von leitfähigen transparenten Schichten auf Papier, von transparenten Wärmeschutzschichten auf Glas oder bei der Herstellung von transparenten Leitfähigkeitsschichten bei Flüssigkristalldisplays. In allen diesen an sich bekannten Verfahren kann mit den erfindungsgemäßen Targets die Gleichspannungszerstäubung eingesetzt werden. In allen diesen Verfahren werden sehr gute transparente Schichten erhalten. Wesentlich dabei ist lediglich, daß die Zerstäubungsatmosphäre einen gewissen Anteil an Sauerstoff enthält. Der jeweils notwendige Sauerstoffgehalt läßt sich leicht durch einige orientierende Versuche feststellen. In der Regel wird er bei etwa 1 bis 20 Vol. % liegen, während der Rest des Anteils zum Beispiel aus Wasserstoff und Argon bestehen kann.

Durch die Erfindung wird daher ein wesentlicher Fortschritt auf dem Gebiet der Hochleistungszerstäubung geschaffen.

## Beispiel 1

In eine zylindrische Graphitform mit 210 mm Innendurchmesser werden 1700 g eines Gemisches aus 1516 g Indiumoxid- und 184 g Zinn(IV)oxidpulver entsprechend einem Molverhältnis von Indium zu Zinn von 9 : 1 gegeben und sowohl gegen den unteren als auch gegen den oberen Graphitpreßstempel mit einer Lage Filterpapier abgedeckt. Nach Einstellen eines Drucks von 70 kg/cm$^2$ wird die Anlage evakuiert und bei konstantem Druck innerhalb von 35 Minuten auf 880°C erhitzt. Die ab etwa 700°C beginnende Verdichtung der Masse wird anhand der Bewegung des Preßstempels registriert. Sobald die Masse bis auf eine Dicke von 9,2 mm zusammengepresst ist, wird die Heizung ausgeschaltet, noch 10 Minuten nachgepresst und dann entspannt. Man erhält eine Keramikplatte mit grauem Aussehen, einer Dicke von 9,2 mm, einer Dichte von 5,3 g/cm$^3$ entsprechend 75 % der theoretischen Dichte und einem spezifischen Widerstand von 0,42 Ω . cm.

## Beispiel 2

In eine zylindrische Graphitform mit 210 mm Innendurchmesser werden 1700 g eines Gemisches aus 1516 g Indiumoxid- und 184 g Zinn(IV)oxidpulver gegeben, wobei zwischen Pulver und Graphitstempel jeweils 2 Lagen Filterpapier eingelegt werden. Nach Einstellen eines Druckes von 70 kg/cm$^2$ wird die Anlage evakuiert und bei konstantem Druck innerhalb von 40 Minuten auf 900°C erhitzt. Sobald die Masse bis auf eine Dicke von 8,3 mm zusammengepresst ist, wird die Heizung ausgeschaltet, noch 10 Minuten nachgepresst und dann entspannt. Man erhält eine Keramikplatte mit grauem Aussehen, einer Dicke von 8,3 mm, einer Dichte von 5,9 g pro cm$^3$ entsprechend 82,7 % der theoretischen Dichte und einen spezifischen Widerstand von 0,38 Ω . cm.

## Beispiel 3

In eine zylindrische Graphitform mit 210 mm Innendurchmesser werden 1700 g eines Gemisches aus 1516 g Indiumoxid- und 184 g Zinn(IV)oxidpulver gegeben, wobei zwischen Pulver und Graphitstempel jeweils 3 Lagen Filterpapier eingelegt werden. Nach Einstellen eines Druckes von 70 kg/cm$^2$, wird die Anlage evakuiert und bei konstantem Druck innerhalb von 45 Minuten auf 920°C erhitzt. Sobald die Masse bis auf eine Dicke von 7,8 mm zusammengepresst ist, wird die Heizung ausgeschaltet, noch 10 Minuten nachgepresst und dann entspannt. Man erhält eine Keramikplatte mit grauem Aussehen, einer Dicke von 7,8 mm, einer Dichte von 6,3 g pro cm$^3$ entsprechend 88,5 % der theoretischen Dichte und einem spezifischen Widerstand von 0,17 Ω . cm.

## Beispiel 4

In eine zylindrische Graphitform mit 210 mm Innendurchmesser werden 1700 g eines Gemisches aus 1608 g Indiumoxid, 92 g Zinn(IV)oxid entsprechend einem Molverhältnis von Indium zu Zinn von 95 : 5, und 34 g Graphitpulver gegeben. Nach Einstellen eines Druckes von 70 kg/cm$^2$, wird die Anlage evakuiert und bei konstantem Druck innerhalb von 35 Minuten auf 880°C erhitzt. Sobald die Masse bis auf eine Dicke von 8,4 mm zusammengepresst ist, wird die Heizung ausgeschaltet, noch 10 Minuten nachgepresst und dann entspannt. Man erhält eine Keramikplatte mit grauem Aussehen, einer Dicke von 8,5 mm, einer Dichte von 5,8 g/cm$^3$ entsprechend 80 % der theoretischen Dichte und einem spezifischen Widerstand von 0,38 Ω . cm.

## Beispiel 5

In eine zylindrische Graphitform mit 210 mm Innendurchmesser, werden 1700 g eines Gemisches aus 1337 g Indiumoxid, 340 g Zinn(IV)oxid und 17 g Zinnpulver entsprechend einem Molverhältnis von Indium zu Zinn von 80 : 20 gegeben. Nach Einstellen eines Druckes von 90 kg/cm$^2$, wird die Anlage evakuiert und innerhalb von 40 Minuten auf 900°C erhitzt. Sobald die Masse bis auf eine Dicke von 8,5 mm zusammengepresst ist, wird die Heizung ausgeschaltet, noch 10 Minuten nachgepresst und dann entspannt. Man erhält eine Keramikplatte mit grauem Aussehen, einer Dicke von 8,5 mm, einer Dichte von 5,77 g/cm$^3$ entsprechend 80 % der theoretischen Dichte und einem spezifischem Widerstand von 0,35 Ω . cm.

## Patentansprüche

1. Oxidkeramische Targets für die magnetfeldverstärkte Kathodenzerstäubung auf Basis von heiß gepressten Indiumoxid/Zinnoxid-Gemischen mit einer Dichte von zumindest 75 % der theoretischen Dichte, dadurch gekennzeichnet, daß sie im Sauerstoffgehalt gegenüber der stöchiometrischen Zusammensetzung so abgereichert sind, daß sie eine elektrische Leitfähigkeit entsprechend einem spezifischen Widerstand von 0,6 bis 0,1 Ω. cm besitzen.

2. Verfahren zur Herstellung von oxidkeramischen Targets nach Anspruch 1 mit einer Dichte von mindestens 75 % der theoretischen Dichte, dadurch gekennzeichnet, daß das Metalloxid-Gemisch in einer reduzierenden Atmosphäre bei einem Druck von 50 bis 600 kg/cm² und einer Temperatur von 850 bis 1000°C so lange verpresst wird, daß das Target eine elektrische Leitfähigkeit entsprechend einem spezifischen Widerstand von 0,6 bis 0,1 Ω. cm erhält.

3. Verfahren nach Anspruch 2, dadurch gekennzeichnet, daß eine Temperatur von 900 bis 920°C und ein Druck von 50 bis 100 kg/cm² eingehalten wird.

4. Verfahren nach Anspruch 2 oder 3, dadurch gekennzeichnet, daß in einer Graphitform gepresst wird.

5. Verfahren nach einem der Ansprüche 2 bis 4, dadurch gekennzeichnet, daß in der Pressform Kohlenstoff oder ein bei der Presstemperatur Kohlenstoff lieferndes organisches Material anwesend ist.

6. Verfahren nach einem der Ansprüche 2 bis 5, dadurch gekennzeichnet, daß dem Metalloxidpulver vor dem Verpressen bis zu 2 Gew.-% Zinn- und/oder Indiumpulver beigefügt wird.

7. Verwendung der Targets nach Anspruch 1 in Gleichspannungs-Zerstäubungsverfahren.

## Claims

1. Oxide-ceramic targets which are to be used in magnetically enhanced cathode sputtering and which are based on hot-pressed indium oxide/tin oxide mixtures having a density of at least 75 % of the theoretical density, characterised in that they have been diminished to such an extent in the oxygen content compared with the stoichiometric composition that they have an electric conductivity which corresponds to a specific resistance of 0.6 to 0.1 Ω. cm.

2. A process for preparing oxide-ceramic targets according to Claim 1, having a density of at least 75 % of the theoretical density, characterised in that the metal oxide mixture is compression-moulded to such an extent in a reducing atmosphere under a pressure of 50 to 600 kg/cm² and at a temperature of 850 to 1,000°C that the target gets an electrical conductivity which corresponds to a specific resistance of 0.6 to 0.1 Ω. cm.

3. A process according to Claim 2, characterised in that a temperature of 900 to 920°C and a pressure of 50 to 100 kg/cm² are maintained.

4. A process according to Claim 2 or 3, characterised in that the compression-moulding takes place in a graphite mould.

5. A process according to any one of Claims 2 to 4, characterised in that carbon or an organic material which produces carbon at the compression-moulding temperature is present in the moulding press.

6. A process according to any one of Claims 2 to 5, characterised in that up to 2 % by weight of tin and/or indium powder are added to the metal oxide powder before the compression-moulding.

7. Use of targets according to Claim 1, in direct-voltage sputtering.

## Revendications

1. Cibles céramiques d'oxyde pour la pulvérisation cathodique à champ magnétique renforcé à base de mélanges oxyde d'indium/oxyde d'étain pressées à chaud, ayant une densité d'au moins 75 % de la densité théorique, caractérisées en ce qu'elles sont tellement appauvries dans leur teneur en oxygène par rapport à la composition stoechiométrique qu'elles possèdent une conductibilité électrique correspondant à une résistance spécifique de. 0,6 à 0,1 Ω. cm.

2. Procédé de préparation de cibles céramiques d'oxyde selon la revendication 1 ayant une densité d'au moins 75 % de la densité théorique, caractérisé en ce que le mélange d'oxydes métalliques est pressé dans une atmosphère réductrice de 50 à 600 kg/cm² et une température de 850 à 1000°C suffisamment longtemps pour que la cible présente une conductibilité électrique correspondant à une résistance spécifique de 0,6 à 0,1 Ω. cm.

3. Procédé selon la revendication 2, caractérisé en ce qu'on maintient une température de 900 à 920°C et une pression de 50 à 100 kg/cm².

4. Procédé selon les revendications 2 ou 3, caractérisé en ce qu'on comprime dans un moule de graphite.

5. Procédé selon l'une des revendications 2 à 4, caractérisé en ce que dans le moule de compression se trouve du carbone ou une matière organique donnant du carbone à la température de compression.

6. Procédé selon l'une des revendications 2 à 5, caractérisé en ce qu'on ajoute à la poudre d'oxyde métallique avant la compression jusqu'à 2 % en poids de poudre d'étain et/ou d'indium.

7. Application des cibles selon la revendication 1 dans des procédés de pulvérisation à tension continue.